# EUROPEAN PATENT APPLICATION

(11) **EP 4 287 240 A1**
(43) Date of publication of application: **06.12.2023**
(21) Application number: 22746044.1
(22) Date of filing: 28.01.2022
(51) Int. Cl.: H01L 21/312, C23C 26/00

(54) **SUBSTRATE, SELECTIVE FILM DEPOSITION METHOD, DEPOSITION FILM OF ORGANIC MATTER, AND ORGANIC MATTER**

(30) Priority: 01.02.2021 JP 2021014552
(71) Applicant: Central Glass Company, Limited, Ube-shi, Yamaguchi 755-0001 (JP)
(72) Inventor: OKADA, Takuya, Ube-shi, Yamaguchi 755-0001 (JP); YAMAMOTO, Junki, Ube-shi, Yamaguchi 755-0001 (JP); TANIGUCHI, Takahisa, Tokyo 101-0054 (JP); YOSHIURA, Kazuki, Ube-shi, Yamaguchi 755-0001 (JP); KONDO, Katsuya, Ube-shi, Yamaguchi 755-0001 (JP); KUMON, Soichi, Ube-shi, Yamaguchi 755-0001 (JP); MIYAZAKI, Tatsuo, Tokyo 101-0054 (JP)
(74) Representative: Mewburn Ellis LLP
(86) International application number: PCT/JP2022/003387
(87) International publication number: WO 2022/163825

(57) **Abstract**

A selective film deposition method includes exposing a substrate having a structure on which a first surface region containing a metal element and a second surface region containing a nonmetal inorganic material are both exposed, to a solution containing an organic substance represented by formula (1) shown below and a solvent to deposit a film of the organic substance on the first surface region selectively over the second surface region: R¹(X)ₘ (1) wherein R¹ is a C4-C100 hydrocarbon group optionally containing a heteroatom or a halogen atom, and m hydrogen atoms of the hydrocarbon group are replaced with X; X is -PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

## Description

### TECHNICAL FIELD

The present disclosure relates to a substrate, a selective film deposition method of selectively depositing a film in a surface region containing a metal element on a substrate, an organic substance deposited film, an organic substance, etc.

### BACKGROUND ART

As recent semiconductor chips have increasingly miniaturized structures, problems such as many steps and high cost exist in conventional lithography in which patterning is carried out by selectively removing a portion of a structure. If chemical vapor deposition (CVD) or atomic layer deposition (ALD) can be used to form a film selectively in a desired region on a substrate, this is considered to be an optimal process for forming a microstructure and solve the above problems.

However, when CVD or ALD is used to selectively deposit a film on a substrate including multiple surface regions of different materials such as metals used in electrodes or wirings and inorganic dielectrics used in insulating films, a film for inhibiting deposition needs to be selectively deposited, but the conventional methods do not have sufficiently high selectivity.

A known selective film formation method includes depositing a material for inhibiting film deposition in a region where film formation is not desired. Patent Literature 1, for example, discloses a method for forming a thin film pattern of an inorganic material such as TiN, AlN, or SiN on a substrate by atomic layer deposition (ALD), which includes: forming a pattern of an atomic layer deposition-inhibiting layer on a substrate by screen printing or the like using an atomic layer deposition-inhibiting material including a fluororesin having a fluorine content of 30 atom% or higher, containing at least one tertiary or quaternary carbon atom, and not containing ester, hydroxyl, carboxyl, or imide groups; and then forming an inorganic material layer by atomic layer deposition in a region where the atomic layer deposition-inhibiting layer is not present.

Moreover, Patent Literature 2 discloses a method for selectively depositing a layer on a substrate including an exposed metal surface and an exposed silicon-containing surface, which includes: (a) growing a first self-assembled monolayer on the exposed metal surface; (b) growing an organosilane-based second self-assembled monolayer on the exposed silicon-containing surface; (c) heating the substrate to remove the first self-assembled monolayer from the exposed metal surface; (d) depositing a low-k dielectric layer or a metal layer selectively on the exposed metal surface; and (e) heating the substrate to remove the second self-assembled monolayer from the exposed silicon-containing surface.

The above method can be applied to a substrate including first and second surfaces of different materials to deposit a film on the first surface selectively over the second surface by using the difference in surface state between the two surfaces. The above method can also reduce the number of steps involved in a process for forming a microstructure.

Moreover, Patent Literature 3, for example, discloses a process which includes subjecting a substrate including a first surface that is a metallic surface and a second surface that is a dielectric surface to a deposition cycle including a step of bringing the substrate into contact with a first gas phase precursor and a step of bringing the substrate into contact with a second gas phase precursor, thereby forming an organic thin film on the first surface selectively over the second surface. It is described in Example 1 of Patent Literature 3 that a 200 mm silicon wafer including tungsten (W) features alternating with silicon oxide surfaces as a substrate was subjected to 250 to 1000 cycles of deposition using 1,6-diaminohexane (DAH) and pyromellitic dianhydride (PMDA) to form a polyimide film, and the polyimide film on the metallic tungsten surface was thicker than the polyimide film on the SiO₂ surface.

Patent Literature 4 discloses a method that uses the selective deposition of an organic film described in Patent Literature 3 to form a passivation layer selectively on a first surface made of a metal, followed by forming a layer X only on a second surface of a dielectric, and also discloses a method that uses the above method to form a metallization structure of an integrated circuit.

### CITATION LIST

### - Patent Literature

Patent Literature 1: WO2016/147941 A1
Patent Literature 2: JP 2018-512504 A
Patent Literature 3: JP 2017-216448 A
Patent Literature 4: JP 2018-137435 A

### SUMMARY OF INVENTION

### - Technical Problem

However, Patent Literature 1, in which a predetermined pattern is formed on a substrate of a single material using an atomic layer deposition-inhibiting material, does not disclose a method of forming an atomic layer deposition-inhibiting layer selectively on a desired surface region on a substrate including multiple surface regions of different materials.

The organosilane-based self-assembled monolayer used in Patent Literature 2 can be deposited selectively on a silicon-containing surface but cannot be deposited selectively on a metal or metal oxide.

The methods of selectively forming an organic thin film described in Patent Literature 3 and Patent Literature 4 involve repeating multiple times a deposition cycle including shifting raw materials and temperatures, and thus require considerable time and effort to form an organic thin film.

In light of the above problems, the present disclosure aims to provide a selective film deposition method which can deposit a film of an organic substance on a surface region containing a metal element selectively over a surface region containing a nonmetal inorganic material on a substrate by a simple procedure, as well as an organic substance deposited film deposited by the method, the organic substance, etc.

### - Solution to Problem

As a result of extensive studies, the present inventors have found that the use of at least one organic substance represented by the formula (1) described below allows a film of the organic substance to be deposited on a surface region containing a metal element selectively over a surface region containing a nonmetal inorganic material on a substrate. This finding has led to the completion of the present invention.

A selective film deposition method according to embodiments of the present disclosure includes exposing a substrate having a structure on which a first surface region containing a metal element and a second surface region containing a nonmetal inorganic material are both exposed, to a solution containing an organic substance represented by formula (1) shown below and a solvent to deposit a film of the organic substance on the first surface region selectively over the second surface region:

R¹(X)ₘ (1)

wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

According to the specified selective film deposition method, it is possible with the use of the organic substance of formula (1) to provide a method which can deposit a film of an organic substance on a first surface region containing a metal element exposed on a substrate selectively over a second surface region containing a nonmetal inorganic material exposed on the substrate by a simple procedure. Herein, a film made of an organic substance is also referred to as a film of an organic substance or an organic substance deposited film.

A substrate according to embodiments of the present disclosure is a substrate including a first surface region containing a metal element and a second surface region containing a nonmetal inorganic material, wherein the first surface region includes a film of the organic substance of formula (1), and the second surface region includes no film of the organic substance or a film of the organic substance on the second surface region has a thickness t₂ smaller than a thickness t₁ of the film of the organic substance on the first surface region.

According to the specified substrate, it is possible to provide a substrate on which a film of the organic substance is deposited on a first surface region containing a metal element selectively over a second surface region containing a nonmetal inorganic material.

An organic substance deposited film according to embodiments of the present disclosure is an organic substance deposited film formed by the specified selective film deposition method, wherein the deposited film includes the organic substance of formula (1) deposited on a substrate.

An organic substance according to embodiments of the present disclosure is the organic substance of formula (1) for use in the specified selective film deposition method.

With the use of the specified organic substance, it is possible to deposit a film of an organic substance on a first surface region containing a metal element exposed on a substrate selectively over a second surface region containing a nonmetal inorganic material exposed on the substrate by a simple procedure.

A solution according to embodiments of the present disclosure is a solution for use in the specified selective film deposition method, wherein the solution contains the organic substance of formula (1) and a solvent.

With the use of the specified solution, it is possible to deposit a film of the organic substance on a first surface region containing a metal element exposed on a substrate selectively over a second surface region containing a nonmetal inorganic material exposed on the substrate by a simple procedure.

### - Advantageous Effects of Invention

According to the selective film deposition method according to embodiments of the present disclosure, it is possible with the use of the organic substance of formula (1) to provide a method which can deposit a film of the organic substance on a first surface region containing a metal element exposed on a substrate selectively over a second surface region containing a nonmetal inorganic material exposed on the substrate by a simple procedure.

According to the substrate according to embodiments of the present disclosure, it is possible to provide a substrate on which a film of the organic substance of formula (1) is deposited on a first surface region containing a metal element exposed on the substrate selectively over a second surface region containing a nonmetal inorganic material exposed on the substrate.

### DESCRIPTION OF EMBODIMENTS

The present disclosure is described in detail below. The following description of structural elements provides exemplary embodiments of the present disclosure. The present disclosure is not limited to such specific contents. Various modifications can be made within the scope of the gist.

A selective film deposition method according to embodiments of the present disclosure includes exposing a substrate having a structure on which a first surface region containing a metal element and a second surface region containing a nonmetal inorganic material are both exposed, to a solution containing an organic substance represented by the formula (1) shown below and a solvent to deposit a film of the organic substance on the first surface region selectively over the second surface region:

R¹(X)ₘ (1)

wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

According to the specified selective film deposition method, it is possible with the use of the organic substance of formula (1) to deposit a film of an organic substance on a first surface region containing a metal element exposed on a substrate selectively over a second surface region containing a nonmetal inorganic material exposed on the substrate by a simple procedure.

Here, the expression "deposit a film of the organic substance on the first surface region selectively over the second surface region" means that the film of the organic substance is deposited on the first surface region, and the film of the organic substance is not deposited on the second surface region or the thickness of the film of the organic substance on the first surface region is greater than the thickness of the film of the organic substance on the second surface region.

Whether the film of the organic substance is deposited or not can be determined by dropping pure water mainly on the surface of the substrate and measuring the angle (contact angle) between the water droplet and the substrate surface by a contact angle meter.

When the organic substance of formula (1) has a poor affinity with water, the contact angle with water increases on a substrate surface on which a film of the organic substance is deposited. In the selective film deposition method according to embodiments of the present disclosure, the contact angle with water is preferably higher in the first surface region than in the second surface region. Specifically, the contact angle with water is preferably higher by at least 10°, more preferably at least 20°, still more preferably at least 30° in the first surface region than in the second surface region.

Thus, it can be determined that a film of the organic substance is deposited on the first surface region with a higher contact angle with water selectively over the second surface region with a lower contact angle with water.

In the present disclosure, the contact angle with water in the first surface region is preferably 80° or more, more preferably 90° or more, still more preferably 100° or more. In contrast, the contact angle with water in the second surface region to which no or only a slight organic substance is attached is preferably about 20 to 70°.

Whether the organic substance deposited film is formed on the substrate or not can also be determined by analyzing the elemental composition on the substrate surface by x-ray photoelectron spectroscopy (XPS). When the organic substance contains a characteristic atom such as phosphorus or sulfur, the peak of that element can be observed.

The easiness of deposition of the organic substance on the first surface region and the second surface region varies depending on the material of the surface regions. Preferably, the thickness t₁ of the film of the organic substance on the first surface region is greater than the thickness t₂ of the film of the organic substance on the second surface region, and the value obtained by dividing t₁ by t₂, i.e., t₁/t₂, is 5 or greater. Further, the value of t₁/t₂ is more preferably 10 or greater, still more preferably 100 or greater. Moreover, the film thickness t₁ is preferably 0.3 nm or more, more preferably 0.6 nm or more, while t₂ is preferably less than 0.3 nm, more preferably 0 nm, i.e., no organic substance is deposited. The thicknesses t₁ and t₂ can be measured by an atomic force microscope (AFM), for example.

The metal element may be at least one metal element selected from the group consisting of Cu, Co, Ru, Ni, Pt, Al, Ta, Ti, and Hf. The metal element may be present in the form of a metal or a compound containing a metal element. The compound containing a metal element may be any compound chemically bound to the metal element, such as a metal oxide, a metal nitride, or an alloy. A metal or a metal oxide is particularly preferred. The metal element is also preferably Cu, Co, or Ru.

Examples of the nonmetal inorganic material include silicon-based materials such as silicon, silicon oxide, silicon nitride, and silicon oxynitride, and germanium-based materials such as germanium, germanium oxide, germanium nitride, and germanium oxynitride. Among these, the nonmetal inorganic material is preferably at least one selected from the group consisting of silicon, silicon oxide, silicon nitride, and silicon oxynitride. The term "silicon" includes both polycrystalline silicon and monocrystalline silicon. The silicon oxide is represented by the chemical formula: SiOₓ where x is at least 1 but not more than 2, such as typically SiO₂. Moreover, the silicon nitride is represented by the chemical formula: SiNₓ where x is at least 0.3 but not more than 9, such as typically Si₃N₄. The silicon oxynitride is represented by Si₄OₓN_{y} where x is at least 3 but not more than 6, and y is at least 2 but not more than 4, such as Si₄O₅N₃.

The first surface region on which a metal is exposed may be prepared, for example, by producing a metal film using chemical vapor deposition (CVD), physical vapor deposition (PVD), plating, or other techniques. For example, a substrate having a structure on which a first surface region containing a metal and a second surface region containing a nonmetal inorganic material are both exposed may be prepared by forming a metal film on a film of a nonmetal inorganic material as described above and forming the metal film into a predetermined pattern by photolithography; or by forming a hole or groove on a film of the nonmetal inorganic material and filling the groove with a metal, optionally followed by chemical mechanical polishing (CMP).

The first surface region on which a metal is exposed may also be prepared by eliminating an oxide film from the surface of a metal film by vapor phase etching or wet etching to expose the metal surface. The oxide film may be mechanically eliminated.

The first surface region in which a metal oxide is exposed may be prepared, for example, by producing a metal oxide film by chemical vapor deposition (CVD), physical vapor deposition (PVD), or other techniques; or by exposing a metal film produced as above to the air to form a natural oxide film. For example, a substrate having a structure on which a first surface region containing a metal oxide and a second surface region containing a nonmetal inorganic material are both exposed may be prepared by forming a metal oxide film on a film of a nonmetal inorganic material as described above and forming the metal oxide film into a predetermined pattern by photolithography; or by forming a hole or groove on a film of the nonmetal inorganic material, filling the groove with a metal, and forming a natural oxide film on the metal.

The first surface region containing a metal element may contain another component other than the compound containing a metal element on which the organic substance of formula (1) can be deposited. However, desirably, the first surface region contains only the compound containing a metal element, and only the compound containing a metal element is exposed on the surface.

The second surface region containing a nonmetal inorganic material may contain a compound of the nonmetal inorganic material or may contain only the nonmetal inorganic material. However, desirably, the second surface region contains only the nonmetal inorganic material, and only the nonmetal inorganic material is exposed on the surface.

Examples of the substrate used in embodiments of the present disclosure include a semiconductor device substrate including a metal or metal oxide film in its structure, and a substrate on which a metal or a metal oxide is formed during a semiconductor device patterning step. Particularly preferred is a substrate in which a predetermined pattern of a metal wiring is formed on a semiconductor element insulating film. In other words, the first surface region corresponds to a metal wiring including a surface natural oxide film or a metal wiring on which a metal is exposed, and the second surface region corresponds to an insulating film made of a nonmetal inorganic material. However, the substrate used in embodiments of the present disclosure is not limited thereto.

Specifically, a film of the organic substance of formula (1) is deposited on the first surface region selectively over the second surface region using a method of exposing the substrate to a solution containing the organic substance and a solvent. This method is described below.

The organic substance to be used is an organic substance represented by the following formula (1):

R¹(X)ₘ (1)

wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

Conceptually, the term "organic substance of formula (1)" encompasses organic substances represented by formulas (2) to (5), and may be, for example, at least one organic substance represented by at least one selected from the group consisting of formulas (2) to (5).

The organic substances of formulas (2) to (5) are described below.

### [Organic substance of formula (2) (including organic substance of formula (6))]

In formula (2) [R³(PO₃(R⁴)₂)ₙ], R³ is a C4-C100 hydrocarbon group optionally containing a heteroatom or a halogen atom, and n hydrogen atoms of the hydrocarbon group are replaced with (PO₃(R⁴)₂); n is 1 or 2; and R⁴ is a hydrogen atom or a C1-C6 alkyl group.

R⁴ is preferably a hydrogen atom. When R⁴ is a hydrogen atom, the organic substance is a phosphonic acid. Here, each R⁴ may be the same or different.

Further, the organic substance of formula (2) [R³(PO₃(R⁴)₂)ₙ] is preferably an organic substance represented by formula (6) [R¹¹-PO₃H₂]. In formula (6), R¹¹ is a C6-C100 monovalent hydrocarbon group optionally containing a heteroatom or a halogen atom.

### [Organic substance of formula (3) (including organic substance of formula (7))]

In formula (3) [R⁵(O-PO₃(R⁶)₂)ₙ], R⁵ is a C4-C100 hydrocarbon group optionally containing a heteroatom or a halogen atom, and n hydrogen atoms of the hydrocarbon group are replaced with (O-PO₃(R⁶)₂); n is 1 or 2; and R⁶ is a hydrogen atom or a C1-C6 alkyl group.

R⁶ is preferably a hydrogen atom. When R⁶ is a hydrogen atom, the organic substance is a phosphate ester. Here, each R⁶ may be the same or different.

Further, the organic substance of formula (3) [R⁵(O-PO₃(R⁶)₂)ₙ] is preferably an organic substance represented by formula (7) [R¹²-O-PO₃H₂]. In formula (7), R¹² is a C6-C100 monovalent hydrocarbon group optionally containing a heteroatom or a halogen atom.

### [Compound of formula (4) (including compound of formula (8))]

In formula (4) [R⁷(CO₂R⁸)ₙ], R⁷ is a C4-C100 hydrocarbon group optionally containing a heteroatom or a halogen atom, and n hydrogen atoms of the hydrocarbon group are replaced with (CO₂R⁸); n is 1 or 2; and R⁸ is a hydrogen atom or a C1-C6 alkyl group.

R⁸ is preferably a hydrogen atom. When R⁸ is a hydrogen atom, the organic substance is a carboxylic acid. Here, each R⁸ may be the same or different.

Further, the organic substance of formula (4) [R⁷(CO₂R⁸)ₙ] is preferably an organic substance represented by formula (8) [R¹³-CO₂H]. In formula (8), R¹³ is a C6-C100 monovalent hydrocarbon group optionally containing a heteroatom or a halogen atom.

### [Organic substance of formula (5) (including organic substance of formula (9))]

In formula (5) [R⁹(SR¹⁰)ₙ], R⁹ is a C4-C100 hydrocarbon group optionally containing a heteroatom or a halogen atom, and n hydrogen atoms of the hydrocarbon group are replaced with (SR¹⁰); n is 1 or 2; and R¹⁰ is a hydrogen atom, a C1-C6 alkyl group, or -S-R⁹.

R¹⁰ is preferably a hydrogen atom. When R¹⁰ is a hydrogen atom, the organic substance is a thiol. Here, each R¹⁰ may be the same or different.

Further, the organic substance of formula (5) [R⁹(SR¹⁰)ₙ] is preferably an organic substance represented by formula (9) [R¹⁴-SH]. In formula (9), R¹⁴ is a C6-C100 monovalent hydrocarbon group optionally containing a heteroatom or a halogen atom.

Examples of the heteroatoms optionally contained in the hydrocarbon groups of R³, R⁵, R⁷, R⁹, R¹¹, R¹², R¹³, and R¹⁴ include nitrogen, oxygen, sulfur, and phosphorus atoms. Examples of the halogen atoms include fluorine, chlorine, bromine, and iodine atoms.

Moreover, R³, R⁵, R⁷, R⁹, R¹¹, R¹², R¹³, and R¹⁴ may each include a branched structure or a cyclic structure. The branched structure contains a secondary or tertiary carbon atom at which the chain is branched. Moreover, examples of the cyclic structure include alicyclic hydrocarbons and aryl groups. Examples of the alicyclic hydrocarbons include cyclopentyl, cyclohexyl, adamantyl, norbornyl, and camphoryl groups. Examples of the aryl groups include phenyl, o-tolyl, m-tolyl, p-tolyl, p-hydroxyphenyl, 1-naphthyl, 1-anthracenyl, and benzyl groups.

Examples of the organic substance of formula (2) or (6) include methylphosphonic acid, ethylphosphonic acid, n-propylphosphonic acid, n-butylphosphonic acid, n-pentylphosphonic acid, n-hexylphosphonic acid, n-heptylphosphonic acid, n-octylphosphonic acid, n-nonylphosphonic acid, n-decylphosphonic acid, n-undecylphosphonic acid, n-dodecylphosphonic acid, n-tridecylphosphonic acid, n-tetradecylphosphonic acid, n-pentadecylphosphonic acid, n-hexadecylphosphonic acid, n-heptadecylphosphonic acid, n-octadecylphosphonic acid, n-nonadecylphosphonic acid, phenylphosphonic acid, (2-phenylethyl)phosphonic acid, (3-phenylpropyl)phosphonic acid, (4-phenylbutyl)phosphonic acid, (5-phenylpentyl)phosphonic acid, (6-phenylhexyl)phosphonic acid, (7-phenylhexyl)phosphonic acid, (8-phenyloctyl)phosphonic acid, (9-phenylnonyl)phosphonic acid, (10-phenyldecyl)phosphonic acid, (11-phenylundecyl)phosphonic acid, (12-phenyldodecyl)phosphonic acid, methylenediphosphonic acid, (4-aminophenyl)phosphonic acid, (4-aminobenzyl)phosphonic acid, benzhydrylphosphonic acid, (4-bromophenyl)phosphonic acid, (2-chloroethyl)phosphonic acid, (3-chloropropyl)phosphonic acid, (4-chlorobutyl)phosphonic acid, (5-chloropentyl)phosphonic acid, (6-chlorohexyl)phosphonic acid, (2-bromoethyl)phosphonic acid, (3-bromopropyl)phosphonic acid, (4-bromobutyl)phosphonic acid, (5-bromopentyl)phosphonic acid, (6-bromohexyl)phosphonic acid, 1,2-ethylenediphosphonic acid, 1,3-propylenediphosphonic acid, 1,4-butanediphosphonic acid, 1,5-pentanediphosphonic acid, 1,6-hexylenediphosphonic acid, alendronic acid, 1,4-phenylenediphosphonic acid, o-xylylenediphosphonic acid, m-xylylenediphosphonic acid, p-xylylenediphosphonic acid, (aminomethyl)phosphonic acid, (1-aminoethyl)phosphonic acid, 2-(perfluorobutyl)ethylphosphonic acid, 2-(perfluorohexyl)ethylphosphonic acid, and 2-(perfluoroheptyl)ethylphosphonic acid.

Examples of the organic substance of formula (3) or (7) include those in which the phosphonyl group (-PO₃H group) of the exemplary phosphonic acids listed above is replaced with -OPO₃H. Examples include n-hexyl phosphate, n-heptyl phosphate, n-octyl phosphate, n-nonyl phosphate, n-decyl phosphate, n-undecyl phosphate, n-dodecyl phosphate, n-tridecyl phosphate, n-tetradecyl phosphate, n-pentadecyl phosphate, n-hexadecyl phosphate, n-heptadecyl phosphate, n-octadecyl phosphate, n-nonadecyl phosphate, phenyl phosphate, benzyl dihydrogen phosphate, 2-phenylethylphosphoric acid, 3-phenylpropylphosphoric acid, 4-phenylbutylphosphoric acid, 5-phenylpentylphosphoric acid, 6-phenylhexylphosphoric acid, 7-phenylheptylphosphoric acid, 8-phenyloctylphosphoric acid, 9-phenylnonylphosphoric acid, 10-phenyldecylphosphoric acid, 11-phenylundecylphosphoric acid, 12-phenyldodecylphosphoric acid, diethyl phosphate, dipropyl phosphate, dibutyl phosphate, dipentyl phosphate, dihexyl phosphate, diheptyl phosphate, dioctyl phosphate, dinonyl phosphate, didecyl phosphate, phenyl phosphate, diphenyl phosphate, dibenzyl phosphate, 2-(perfluorobutyl)ethylphosphoric acid, 2-(perfluoropentyl)ethylphosphoric acid, 2-(perfluorohexyl)ethylphosphoric acid, and 2-(perfluoroheptyl)ethylphosphoric acid.

Examples of the organic substance of formula (4) or (8) include those in which the phosphonyl group (-PO₃H group) of the exemplary phosphonic acids listed above is replaced with -CO₂H. Examples include n-hexanoic acid, n-heptanoic acid, n-octanoic acid, n-nonanoic acid, n-decanoic acid, n-undecanoic acid, n-dodecanoic acid, n-tridecanoic acid, n-tetradecanoic acid, n-pentadecanoic acid, n-hexadecanoic acid, n-heptadecanoic acid, n-octadecanoic acid, n-nonadecanoic acid, benzoic acid, 2-phenylethanoic acid, 3-phenylpropanoic acid, 4-phenylbutanoic acid, 5-phenylpentanoic acid, 6-phenylhexanoic acid, 7-phenylheptanoic acid, 8-phenyloctanoic acid, 9-phenylnonanoic acid, 10-phenyldecanoic acid, 11-phenylundecanoic acid, 12-phenyldodecanoic acid, 1,2-ethanedicarboxylic acid, 1,3-propanedicarboxylic acid, 1,4-butanedicarboxylic acid, 1,5-pentanedicarboxylic acid, 1,6-hexanedicarboxylic acid, 1,7-heptanedicarboxylic acid, 1,8-octanedicarboxylic acid, 1,9-nonanedicarboxylic acid, 1,10-decanedicarboxylic acid, 1,11-undecanedicarboxylic acid, 1,12-dodecanedicarboxylic acid, 1,13-tridecanedicarboxylic acid, 1,14-tetradecanedicarboxylic acid, 1,15-pentadecanedicarboxylic acid, 1,16-hexadecanedicarboxylic acid, 1,17-heptadecanedicarboxylic acid, 1,2-cyclohexanedicarboxylic acid, 1,4-cyclohexanedicarboxylic acid, 1,3-cyclohexanedicarboxylic acid, diethylmalonic acid, dipropylmalonic acid, dibutylmalonic acid, dipentylmalonic acid, dihexylmalonic acid, o-phthalic acid, m-phthalic acid, p-phthalic acid, 2-(perfluorobutyl)ethanoic acid, 2-(perfluoropentyl)ethanoic acid, 2-(perfluorohexyl)ethanoic acid, 2-(perfluoroheptyl)ethanoic acid, 2-(perfluorohexyl)propanoic acid, perfluoro-1,4-butanedioic acid, perfluoro-1,5-pentanedioic acid, perfluoro-1,6-hexanedioic acid, perfluoro-1,7-heptanedioic acid, perfluoro-1,8-octanedioic acid, 4,4'-bisbenzoic acid, and 4,4'-(hexafluoroisopropylidene)bis(benzoic acid).

Examples of the organic substance of formula (5) or (9) include those in which the phosphonyl group (-PO₃H group) of the exemplary phosphonic acids listed above is replaced with -SH. Examples include n-hexanethiol, n-heptanethiol, n-octanethiol, n-nonanethiol, n-decanethiol, n-undecanethiol, n-dodecanethiol, n-tridecanethiol, n-tetradecanethiol, n-pentadecanethiol, n-hexadecanethiol, n-heptadecanethiol, n-octadecanethiol, n-nonadecanethiol, cyclohexanethiol, thiophenol, phenylmethanethiol, 2-phenylethanethiol, 3-phenylpropanethiol, 4-phenylbutanethiol, 5-phenylpentanethiol, 6-phenylhexanethiol, 7-phenylheptanethiol, 8-phenyloctanethiol, 9-phenylnonanethiol, 10-phenyldecylthiol, 11-phenylundecylthiol, 12-phenyldodecylthiol, ethanedithiol, 1,3-propanedithiol, 1,4-butanedithiol, 1,5-pentanedithiol, 1,6-hexanedithiol, 1,7-heptanedithiol, 1,8-octanedithiol, 1,9-nonanedithiol, 1,10-decanedithiol, 1,11-undecanedithiol, 1,12-dodecanedithiol, 1,13-tridecanedithiol, 1,14-tetradecanedithiol, 1,15-pentadecanedithiol, 1,16-hexadecanedithiol, 1,17-heptadecanedithiol, 1,18-octadecanedithiol, 1,19-nonadecanedithiol, 1,2-benzenedithiol, 1,3-benzenedithiol, 1,4-benzenedithiol, 1,4-benzenedimethanethiol, 2-(perfluorobutyl)ethanethiol, 2-(perfluoropentyl)ethanethiol, 2-(perfluorohexyl)ethanethiol, and 2-(perfluoroheptyl)ethanethiol.

The hydrogen atoms in each of R¹, R³, R⁵, R⁷, R⁹, R¹¹, R¹², R¹³, and R¹⁴ are preferably partially or fully replaced with fluorine atoms because the heat resistance can be improved. In particular, the hydrogen atoms are preferably replaced with a plurality of fluorine atoms. More preferably, a perfluoroalkyl group is present.

Moreover, to increase the amount of the organic substance deposited, R¹¹, R¹², R¹³, and R¹⁴ are each preferably a monovalent organic group represented by the following formula (10):

R¹⁵-(CH₂)ₙ- (10)

wherein R¹⁵ is a hydrogen atom or a monovalent hydrocarbon group optionally containing a heteroatom or a halogen atom; and n is an integer of 2 to 20, and the total number of carbons in formula (10) is 6 to 100.

Again, to increase the amount of the organic substance deposited, R¹¹, R¹², R¹³, and R¹⁴ are each preferably a monovalent organic group represented by the following formula (11):

R¹⁶-O-Y-((CH₂)ₚO)_{q}-Z-(CH₂)ᵣ- (11)

wherein R¹⁶ is a hydrogen atom, a methyl group, or a phenyl group; Y and Z are each any divalent group or a direct bond; p is an integer of 1 to 4, and q and r are positive integers; the total number of carbons in formula (11) is 6 to 100; and the repeating units (CH₂)ₚO and CH₂ may be present in any order in the formula.

Further, formula (11) is preferably R¹⁶-O-((CH₂)ₚO)_{q}-(CH₂)ᵣ-, and the total number of carbons in formula (11) is preferably 10 to 90, more preferably 20 to 80.

Moreover, to increase the amount of the organic substance deposited, R¹, R³, R⁵, R⁷, R⁹, R¹¹, R¹², R¹³, and R¹⁴ are each preferably a linear hydrocarbon group not containing a branched structure. The linear hydrocarbon group may contain a cyclic structure. The cyclic structure is preferably an aryl group, particularly a phenyl group, and is preferably present at the tip of the linear hydrocarbon group.

In the selective film deposition method according to embodiments of the present disclosure, the substrate is exposed to a solution containing the organic substance of formula (1) and a solvent to deposit a film of the organic substance on the first surface region selectively over the second surface region.

The phrase "the substrate is exposed to the solution" means bringing the surface of the substrate into contact with the solution.

A specific example of the selective film deposition method may include immersing a substrate including a first surface region and a second surface region in a solution containing the organic substance of formula (1) and a solvent to bring the solution into contact with the surface of the substrate and deposit a film of the organic substance selectively on the first surface region of the substrate. The above method is referred to as the immersion method.

In addition to the immersion method in which the substrate is immersed in the solution, the substrate may be exposed to the solution by a method such as a spin coating method in which the solution is dropped onto the substrate and the substrate is then rotated at a high speed; a spray coating method in which the solution is sprayed to the substrate; or an application method in which the solution is applied to the substrate. The method is not limited to these methods as long as it can bring the substrate into contact with the solution.

The concentration of the organic substance of formula (1) in the solution is preferably at least 0.01 mass% but not more than 20 mass%, more preferably at least 0.05 mass% but not more than 10 mass%, still more preferably at least 0.1 mass% but not more than 8 mass%, particularly preferably at least 0.3 mass% but not more than 5 mass%, based on 100 mass% of the total amount of the solution. When the solution contains two or more such organic substances, the concentration range indicated above means the total concentration of these organic substances.

The solvent used in the solution of the present disclosure may be any conventionally known solvent that can dissolve the above-described organic substance and that causes little damage to the surface of the workpiece. In order to be able to dissolve the organic substance and to cause little damage to the surface of the workpiece, the solvent preferably includes an organic solvent (nonaqueous solvent) excluding water. In view of the solubility of the organic substance, the solvent preferably includes an organic solvent (nonaqueous solvent) other than hydrocarbon-based solvents.

Suitable examples of the nonaqueous solvent other than hydrocarbon-based solvents include esters, ethers, ketones, sulfoxide-based solvents, sulfone-based solvents, lactone-based solvents, carbonate-based solvents, alcohol-based solvents, polyhydric alcohol derivatives, nitrogen element-containing solvents, silicone solvents, and mixtures thereof.

Examples of the esters include ethyl acetate, n-propyl acetate, i-propyl acetate, n-butyl acetate, i-butyl acetate, n-pentyl acetate, i-pentyl acetate, n-hexyl acetate, n-heptyl acetate, n-octyl acetate, n-pentyl formate, n-butyl propionate, ethyl butyrate, n-propyl butyrate, i-propyl butyrate, n-butyl butyrate, methyl n-octanoate, methyl decanoate, methyl pyruvate, ethyl pyruvate, n-propyl pyruvate, methyl acetoacetate, ethyl acetoacetate, ethyl 2-oxobutanoate, dimethyl adipate, methyl 3-methoxypropionate, ethyl 3-methoxypropionate, methyl 3-ethoxypropionate, ethyl 3-ethoxypropionate, and ethyl ethoxyacetate.

Examples of the ethers include di-n-propyl ether, ethyl-n-butyl ether, di-n-butyl ether, ethyl-n-amyl ether, di-n-amyl ether, ethyl-n-hexyl ether, di-n-hexyl ether, din-octyl ether, ethers containing a branched hydrocarbon group corresponding to the number of carbons of any of the foregoing ethers (such as diisopropyl ether and diisoamyl ether), dimethyl ether, diethyl ether, methyl ethyl ether, methyl cyclopentyl ether, diphenyl ether, tetrahydrofuran, dioxane, methyl perfluoropropyl ether, methyl perfluorobutyl ether, ethyl perfluorobutyl ether, methyl perfluorohexyl ether, and ethyl perfluorohexyl ether.

Examples of the ketones include acetone, acetylacetone, methyl ethyl ketone, methyl propyl ketone, methyl butyl ketone, 2-heptanone, 3-heptanone, cyclohexanone, and isophorone.

Examples of the sulfoxide-based solvents include dimethyl sulfoxide. Examples of the sulfone-based solvents include dimethyl sulfone, diethyl sulfone, bis(2-hydroxyethyl)sulfone, and tetramethylene sulfone.

Examples of the lactone-based solvents include β-propiolactone, γ-butyrolactone, γ-valerolactone, γ-hexanolactone, γ-heptanolactone, γ-octanolactone, γ-nonanolactone, γ-decanolactone, γ-undecanolactone, γ-dodecanolactone, δ-valerolactone, δ-hexanolactone, δ-octanolactone, δ-nonanolactone, δ-decanolactone, δ-undecanolactone, δ-dodecanolactone, and ε-hexanolactone.

Examples of the carbonate-based solvents include dimethyl carbonate, ethyl methyl carbonate, diethyl carbonate, and propylene carbonate. Examples of the alcohol-based solvents include methanol, ethanol, propanol, butanol, pentanol, hexanol, heptanol, octanol, ethylene glycol, diethylene glycol, 1,3-propanediol, 1,2-propanediol, dipropylene glycol, 1,2-butanediol, 1,3-butanediol, 1,4-butanediol, triethylene glycol, tripropylene glycol, tetraethylene glycol, tetrapropylene glycol, and glycerol.

Examples of the polyhydric alcohol derivatives include OH-group containing polyhydric alcohol derivatives such as ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, triethylene glycol monomethyl ether, triethylene glycol monoethyl ether, triethylene glycol monopropyl ether, triethylene glycol monobutyl ether, tetraethylene glycol monomethyl ether, tetraethylene glycol monoethyl ether, tetraethylene glycol monopropyl ether, tetraethylene glycol monobutyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, dipropylene glycol monobutyl ether, tripropylene glycol monomethyl ether, tripropylene glycol monoethyl ether, tripropylene glycol monopropyl ether, tripropylene glycol monobutyl ether, tetrapropylene glycol monomethyl ether, and butylene glycol monomethyl ether; and OH group-free polyhydric alcohol derivatives such as ethylene glycol dimethyl ether, ethylene glycol diethyl ether, ethylene glycol dibutyl ether, ethylene glycol monomethyl ether acetate, ethylene glycol monoethyl ether acetate, ethylene glycol monobutyl ether acetate, ethylene glycol diacetate, diethylene glycol dimethyl ether, diethylene glycol ethyl methyl ether, diethylene glycol diethyl ether, diethylene glycol butyl methyl ether, diethylene glycol dibutyl ether, diethylene glycol monomethyl ether acetate, diethylene glycol monoethyl ether acetate, diethylene glycol monobutyl ether acetate, diethylene glycol diacetate, triethylene glycol dimethyl ether, triethylene glycol diethyl ether, triethylene glycol dibutyl ether, triethylene glycol butyl methyl ether, triethylene glycol monomethyl ether acetate, triethylene glycol monoethyl ether acetate, triethylene glycol monobutyl ether acetate, triethylene glycol diacetate, tetraethylene glycol dimethyl ether, tetraethylene glycol diethyl ether, tetraethylene glycol dibutyl ether, tetraethylene glycol monomethyl ether acetate, tetraethylene glycol monoethyl ether acetate, tetraethylene glycol monobutyl ether acetate, tetraethylene glycol diacetate, propylene glycol dimethyl ether, propylene glycol diethyl ether, propylene glycol dibutyl ether, propylene glycol monomethyl ether acetate (propylene glycol 1-monomethyl ether 2-acetate), propylene glycol monoethyl ether acetate, propylene glycol monobutyl ether acetate, propylene glycol diacetate, dipropylene glycol dimethyl ether, dipropylene glycol methyl propyl ether, dipropylene glycol diethyl ether, dipropylene glycol dibutyl ether, dipropylene glycol monomethyl ether acetate, dipropylene glycol monoethyl ether acetate, dipropylene glycol monobutyl ether acetate, dipropylene glycol diacetate, tripropylene glycol dimethyl ether, tripropylene glycol diethyl ether, tripropylene glycol dibutyl ether, tripropylene glycol monomethyl ether acetate, tripropylene glycol monoethyl ether acetate, tripropylene glycol monobutyl ether acetate, tripropylene glycol diacetate, tetrapropylene glycol dimethyl ether, tetrapropylene glycol monomethyl ether acetate, tetrapropylene glycol diacetate, butylene glycol dimethyl ether, butylene glycol monomethyl ether acetate, butylene glycol diacetate, glycerin triacetate, 3-methoxybutyl acetate, 3-methyl-3-methoxybutyl acetate, and 3-methyl-3-methoxybutyl propionate.

Examples of the nitrogen element-containing solvents include N,N-dimethylformamide, N,N-dimethylacetamide, N,N-diethylacetamide, N-methyl-2-pyrrolidone, N-ethyl-2-pyrrolidone, N-propyl-2-pyrrolidone, 1,3-dimethyl-2-imidazolidinone, 1,3-diethyl-2-imidazolidinone, 1,3-diisopropyl-2-imidazolidinone, triethylamine, and pyridine.

Examples of the silicone solvents include hexamethyldisiloxane, octamethyltrisiloxane, decamethyltetrasiloxane, and dodecamethylpentasiloxane.

Moreover, in view of the solubility of the organic substance, the organic solvent is preferably a polar organic solvent. Preferably, the organic solvent includes at least one selected from the group consisting of esters, ethers, ketones, alcohol-based solvents, and polyhydric alcohol derivatives, particularly preferably alcohol-based solvents, suitably ethanol or isopropyl alcohol (IPA).

Here, the solvent may contain water. In this case, the water concentration is preferably 40 mass% or less, particularly 20 mass% or less or even 10 mass% or less, based on 100 mass% of the solution of the present disclosure.

Moreover, a catalyst may be added to the solution of the present disclosure in order to promote the formation of an organic substance deposited film. Examples of the catalyst include acidic compounds such as hexafluoroisopropanol, trifluoroacetic acid, trifluoroacetic anhydride, trifluoromethanesulfonic acid, and trifluoromethanesulfonic anhydride; and basic compounds such as pyridine, N,N-dimethyl-4-aminopyridine, ammonia, and imidazole. The amount of the catalyst added is preferably 0.01 to 50 mass% based on 100 mass% of the total amount of the organic substance.

The temperature of the solution in the immersion method, etc. is preferably 0 to 80°C. The time during which the substrate is immersed in the solution is preferably at least 10 seconds but not more than 48 hours, more preferably at least 1 minute but not more than 24 hours. When the substrate is immersed in the solution, the solution may be stirred with a stirring blade or the like.

Moreover, after the substrate is exposed to the solution containing the organic substance to deposit a film of the organic substance thereon, a washing step of washing the substrate with a solvent is preferably performed. Examples of solvents that may be used in the washing step include the organic solvents listed above. The washing method preferably includes immersion in the solvent at 0 to 80°C for 1 to 1000 seconds. When the substrate is immersed in the solution containing the organic substance, the substrate will be pulled out of the solution and washed with the solvent.

After the washing step, preferably, inert gas such as nitrogen or argon is sprayed to the substrate to dry the substrate. The temperature of the inert gas to be sprayed is preferably 0 to 80°C.

In the selective film deposition method according to embodiments of the present disclosure in which the substrate having a structure on which the first surface region and the second surface region are both exposed is exposed to the solution containing the organic substance of formula (1) and a solvent to deposit a film of the organic substance on the first surface region selectively over the second surface region, when the substrate is exposed to the solution, the substrate may be exposed to a single solution as the solution to deposit a film of the organic substance on the first surface region selectively over the second surface region; or alternatively, two or more solutions may be provided as the solution and the substrate may be sequentially exposed to the solutions to deposit a film of the organic substance on the first surface region selectively over the second surface region.

In this case, desirably, the substrate is exposed to the first solution, followed by washing with the solvent described above and drying, and subsequently the substrate is exposed to the second solution, also followed by washing with the solvent described above and drying. When three solutions are provided as the solution, the step of washing with the solvent described above and drying is also desirably performed every time after the substrate is exposed to one solution but before the substrate is exposed to the subsequent solution. However, the washing and drying step may be omitted in some cases.

Moreover, the number of carbons of R¹ for the organic substance contained in the second or subsequent solution to which the substrate is exposed may be smaller than the number of carbons of R¹ for the organic substance contained in the first solution to which the substrate is exposed. However, the aforementioned number of carbons for the organic substance contained in the second or subsequent solution to which the substrate is exposed is desirably set to be greater than or equal to the aforementioned number of carbons for the organic substance contained in the first solution to which the substrate is exposed.

When the number of carbons of R¹ for the organic substance contained in the second or subsequent solution to which the substrate is exposed is greater than or equal to the number of carbons of R¹ for the organic substance contained in the first solution to which the substrate is exposed, the resulting substrate may have a much higher contact angle, so that a thicker film of the organic substance can be deposited selectively on the first surface region.

In the exposure of the substrate to the solution, when two or more solutions are provided as the solution and the substrate is sequentially exposed to the solutions, a film of the organic substance can be deposited on the first surface region selectively over the second surface region even if the time during which the substrate is exposed to each solution, i.e., the time during which the substrate is immersed in each solution, is reduced.

### [Substrate after selective deposition of organic substance deposited film]

A substrate according to embodiments of the present disclosure is a substrate including a first surface region containing a metal element and a second surface region containing a nonmetal inorganic material, wherein the first surface region includes a film of the organic substance of formula (1), and the second surface region includes no film of the organic substance or a film of the organic substance on the second surface region has a thickness t₂ smaller than the thickness t₁ of the film of the organic substance on the first surface region.

The contact angle with water is preferably higher, more preferably by 10° or more, in the first surface region than in the second surface region.

The film (deposited film) of the organic substance may be one physically adsorbed onto the first surface region or may be one chemically bound to the component contained in the substrate. The group containing a phosphorus atom, an oxygen atom, or a sulfur atom in the molecule of the organic substance described above is believed to be provided by interacting with the metal or metal oxide contained in the substrate. In this case, the film of the organic substance is believed to have a monolayer structure. The substrate surface before the deposition of the organic substance is often hydrophilic due to the metal or metal oxide contained in the substrate, while the substrate surface after the deposition of the organic substance is often hydrophobic due to the film of the organic substance. When the organic substance used is any of the organic substances described above, the phosphorus atom, oxygen atom, or sulfur atom is believed to interact with the metal or metal oxide to expose a hydrocarbon group such as an alkyl group on the surface of a film of the organic substance, and thus the deposition of the film of the organic substance is believed to make the first surface region hydrophobic.

Hence, when pure water is dropped on the first surface region on which the organic substance has been deposited and the angle (contact angle) between a water droplet and the wafer surface is measured by a contact angle meter, it is believed that the contact angle is higher in the first surface region than in the second surface region.

### EXAMPLES

Hereinafter, examples that more specifically disclose embodiments of the present disclosure are described. It should be noted that the present disclosure is not limited to these examples.

### [Example 1]

### (Preparation of solution)

Isopropyl alcohol (IPA) as a solvent and n-octadecanoic acid as an organic substance were mixed and dissolved so that the organic substance was at a concentration of 1 mass%, whereby a solution containing n-octadecanoic acid and the solvent was prepared.

### (Preparation of substrate)

A silicon substrate having a 100 nm thick cobalt film was irradiated with UV/O₃ for 30 minutes (lamp: EUV200WS; distance from lamp: 10 mm; UV irradiation can generate ozone from oxygen in the air) to oxidize the surface, whereby a substrate having a cobalt oxide film (CoOₓ) on the surface was obtained.

A silicon substrate having a 100 nm thick cobalt film was immersed in an aqueous solution of HF at a concentration of 0.5 mass% at 22°C for one minute to remove the natural oxide film from the surface, whereby a substrate having a cobalt film (Co) on the surface was obtained.

A silicon substrate having a 100 nm thick copper film was washed by UV/O₃ irradiation (lamp: EUV200WS; distance from lamp: 10 mm; UV irradiation can generate ozone from oxygen in the air) for 30 minutes, whereby a substrate having a copper oxide film (CuOₓ) on the surface was obtained.

A silicon substrate having a 100 nm thick copper film was immersed in an aqueous solution of HF at a concentration of 0.5 mass% at 22°C for one minute to remove the natural oxide film from the surface, whereby a substrate having a copper film (Cu) on the surface was obtained.

A silicon substrate having a 100 nm thick silicon oxide film was immersed in an aqueous solution of HF at a concentration of 0.5 mass% at 22°C for one minute, and the surface was washed, whereby a substrate having a silicon oxide (SiOₓ) film on the surface was obtained.

A silicon substrate having a 30 nm thick silicon nitride film was immersed in an aqueous solution of HF at a concentration of 0.5 mass% at 22°C for one minute to remove the natural oxide film from the surface, whereby a substrate having a silicon nitride film (SiN) on the surface was obtained.

A silicon substrate was immersed in an aqueous solution of HF at a concentration of 0.5 mass% at 22°C for one minute to remove the natural oxide film from the surface, whereby a substrate (Si substrate) having a silicon surface was obtained.

### (Surface treatment with solution containing organic substance)

The seven substrates prepared by the above treatments were each immersed in the solution described above at 22°C for 24 hours for surface treatment of the substrate to deposit the organic substance on the surface of the substrate. Subsequently, the substrates were immersed in IPA 60 seconds twice, and nitrogen gas was sprayed for 60 seconds to dry the substrates.

### (Measurement of contact angle with water)

Pure water (about 1 ul) was placed on the surface of each of the seven substrates according to Example 1 which had been subjected to surface treatment with the solution containing the organic substance, and the angle (contact angle) between a water droplet and the wafer surface was measured by a contact angle meter (DM-301 available from Kyowa Interface Science Co., Ltd.). Table 1 shows the results.

**[Table 1]**

| | Organic substance | Organic substance concentration (mass%) | Solvent | Contact angle (°) | | | | | | |
|---|---|---|---|---|---|---|---|---|---|---|
| | | | | CoOx | Co | CuOx | Cu | SiOx | SiN | Si |
| Example 1 | n-Octadecanoic acid | 1 | IPA | 109 | 108 | 109 | 109 | 29 | 32 | 32 |

As a result of the measurement of the contact angle by the above method, the CuOₓ substrate, Cu substrate, CoOₓ substrate, and Co substrate each had a higher contact angle than the Si substrate, SiN substrate, and SiOₓ substrate, as shown in Table 1, demonstrating that the use of a carboxylic acid as an organic substance allows a film of the organic substance to be deposited selectively on a metal or metal oxide surface.

### [Examples 2 to 20]

The procedure was repeated as in Example 1, except that the type of the substance of the substrate surface, the type of the organic substance, the type of the solvent, the concentration (organic substance concentration) of the solution, and the like were changed as shown in Table 2, followed by evaluation. In other words, in these examples, CoOₓ substrates, Co substrates, and SiOₓ substrates were prepared. Table 2 shows the results.

### [Comparative Examples 1 and 2]

In Comparative Example 1, as shown in Table 2, an IPA solution not containing any of the above-mentioned organic substances was used. In Comparative Example 2, as shown in Table 2, PGMEA as a solvent and trimethylsilyldimethylamine as an organic substance were mixed and dissolved so that the organic substance was at the concentration shown in Table 2, whereby a solution containing the organic substance and the solvent was prepared. It should be noted that trimethylsilyldimethylamine does not correspond to an organic substance of formula (1).

### (Preparation of substrate and Surface treatment with solution)

In Comparative Examples 1 and 2, the same substrates as in Examples 2 to 20 were prepared and subjected to surface treatment with the respective solutions as in Examples 2 to 20.

### (Measurement of contact angle with water)

Pure water (about 1 ul) was placed on the surface of each of the substrates according to Comparative Examples 1 and 2, and the angle (contact angle) between a water droplet and the wafer surface was measured by a contact angle meter (DM-301 available from Kyowa Interface Science Co., Ltd.). Table 2 shows the results.

**[Table 2]**

| | Organic substance | Organic substance concentration (mass%) | Solvent | Contact angle (°) | | |
|---|---|---|---|---|---|---|
| | | | | CoOx | Co | SiOx |
| Example 2 | 2-(Perfluorohexyl)propanoic acid | 1 | IPA | 108 | 109 | 30 |
| Example 3 | n-Octadecvlphosphonic acid | 1 | IPA | 112 | 109 | 38 |
| Example 4 | 2-(Perfluorohexyl)ethylphosphonic acid | 1 | IPA | 109 | 107 | 39 |
| Example 5 | n-Octadecanethiol | 1 | IPA | 110 | 112 | 45 |
| Example 6 | 2-(Perfluorohexvl)ethanethiol | 1 | IPA | 101 | 102 | 31 |
| Example 7 | n-Octadecanoic acid | 1 | EtOH | 106 | 106 | 68 |
| Example 8 | n-Octadecylphosphonic acid | 1 | EtOH | 112 | 110 | 35 |
| Example 9 | n-Octadecanethiol | 1 | EtOH | 111 | 109 | 42 |
| Example 10 | n-Octadecanoic acid | 0.1 | PGMEA | 102 | 102 | 60 |
| Example 11 | n-Octadecylphosphonic acid | 0.1 | PGMEA | 105 | 106 | 35 |
| Example 12 | n-Octadecanethiol | 0.1 | PGMEA | 106 | 107 | 41 |
| Example 13 | n-Octadecanoic acid | 0.1 | IPA | 101 | 101 | 28 |
| Example 14 | n-Octadecanoic acid | 10 | IPA | 112 | 112 | 31 |
| Example 15 | n-Octadecanoic acid | 1 | THF | 100 | 101 | 32 |
| Example 16 | n-Octadecvlphosphonic acid | 1 | THF | 109 | 109 | 35 |
| Example 17 | n-Octadecanethiol | 1 | THF | 106 | 107 | 42 |
| Example 18 | n-Octadecanoic acid | 1 | EtOAc | 102 | 101 | 30 |
| Example 19 | n-Octadecvlphosphonic acid | 0.1 | EtOAc | 110 | 111 | 35 |
| Example 20 | n-Octadecanethiol | 1 | EtOAc | 108 | 108 | 40 |
| Comparative Example 1 | None | 0 | IPA | 74 | 71 | 35 |
| Comparative Example 2 | Trimethylsilyldimethylamine | 1 | PGMEA | 75 | 73 | 101 |

| | | | | | | |
|---|---|---|---|---|---|---|
| Note) EtOH: ethanol; PGMEA: propylene glycol 1-monomethyl ether 2-acetate; THF: tetrahydrofuran; EtOAc: ethyl acetate | | | | | | |

As is clear from the results in Table 2, in each of Examples 2 to 20, the Co substrate or CoOₓ substrate had a higher contact angle than the SiOₓ substrate, demonstrating that the use of an organic substance of formula (1) as an organic substance allows a film of the organic substance to be deposited selectively on a metal or metal oxide surface.

In contrast, in each of Comparative Examples 1 and 2 in which no or another organic substance was used, the contact angles of the Co substrate and CoOₓ substrate did not increase. In particular, in Comparative Example 2, the SiOₓ substrate had a higher contact angle than the CoOₓ substrate and Co substrate, and it is considered that trimethylsilyldimethylamine was deposited selectively on the SiOₓ substrate.

### (Elemental composition analysis by x-ray photoelectron spectroscopy (XPS) on substrates obtained in Examples)

Of the examples described above, the substrates obtained in the examples with the numbers shown in Table 3 below were subjected to analysis of the elemental composition of the substrate surface by x-ray photoelectron spectroscopy (XPS). Table 3 shows the results.

**[Table 3]**

| | Organic substance | Organic substance concentration (mass%) | Solvent | Surface elemental composition | | |
|---|---|---|---|---|---|---|
| | | | | CoOₓ | Co | SiOₓ |
| Example 3 | n-Octadecylphosphonic acid | 1 | IPA | P | P | - |
| Example 4 | 2-(Perfluorohexyl)ethylphosphonic acid | 1 | IPA | P | P | - |
| Example 5 | n-Octadecanethiol | 1 | IPA | S | S | - |
| Example 6 | 2-(perfluorohexyll)ethanethiol | 1 | IPA | S | S | - |
| Example 8 | n-Octadecylphosphonic acid | 1 | EtOH | P | P | - |
| Example 9 | n-Octadecanethiol | 1 | EtOH | S | S | - |
| Example 11 | n-Octadecylphosphonic acid | 0.1 | PGMEA | P | P | - |
| Example 12 | n-Octadecanethiol | 0.1 | PGMEA | S | S | - |
| Example 16 | n-Octadecylphosphonic acid | 1 | THF | P | P | - |
| Example 17 | n-Octadecanethiol | 1 | THF | S | S | - |
| Example 19 | n-Octadecylphosphonic acid | 0.1 | EtOAc | P | P | - |
| Example 20 | n-Octadecanethiol | 1 | EtOAc | S | S | - |

| | | | | | | |
|---|---|---|---|---|---|---|
| Note) EtOH: ethanol; PGMEA: propylene glycol 1-monomethyl ether 2-acetate; THF: tetrahydrofuran; EtOAc: ethyl acetate | | | | | | |

As is clear from the results in Table 3, the surface of the Co substrate or CoOₓ substrate obtained in each of the examples shown in Table 3 was found to exhibit an intense peak of the characteristic element contained in the organic substance used, i.e., a P element in the case of the phosphonic acids, or a S element in the case of the thiols. In contrast, no peaks of a P element, a S element, etc. were observed on the surface of the SiOₓ substrate.

Thus, it is believed that a phosphonic acid or thiol film was formed on the Co substrate and CoOₓ substrate.

### [Examples 21 to 27]

### (Evaluation of heat resistance)

The same procedure as in Example 1 was followed using the organic substance shown in Table 4 to form a film of the organic substance on the surface of a CoOₓ film. The thus prepared substrate was set in a quartz tube, which was then evacuated in vacuo for one hour using an oil pump and then heated to heat the substrate.

The heating was stopped after one hour from the time when the temperature of the substrate reached a predetermined temperature. After cooling for 30 minutes, the substrate was taken out. The substrate after heating was measured for contact angle with water as described above in "Measurement of contact angle with water". The heating temperature was increased from 100°C by an increment of 50°C, and the highest heating temperature at which heating decreases the contact angle by 10° or less was regarded as the heat resistance temperature. Here, if the highest heating temperature (heat resistance temperature) was 100°C, this means that the difference between the contact angle of the substrate before heating and the contact angle of the substrate heated at 100°C was 10°C or less, but heating at 150°C decreased the contact angle by more than 10°C.

**[Table 4]**

| | Organic substance | Organic substance concentration (mass%) | Solvent | Heat resistance temperature (°C) |
|---|---|---|---|---|
| Example 21 | n-Octadecanoic acid | 1 | IPA | 150 |
| Example 22 | n-Nonanoic acid | 1 | IPA | 100 |
| Example 23 | 2-(Perfluorohexyl)propanoic acid | 1 | IPA | 150 |
| Example 24 | n-Octadecylphosphonic acid | 1 | IPA | 250 |
| Example 25 | 2-(Perfluorohexyl)ethylphosphonic acid | 1 | IPA | 300 |
| Example 26 | n-Octadecanethiol | 1 | IPA | 150 |
| Example 27 | 2-(Perfluorohexyl)ethanethiol | 1 | IPA | 200 |

As is clear from Table 4, each of the organic substances used in Examples 21 to 27, after being deposited on the substrate, was found to be less likely to disappear from the substrate due to degradation, desorption, etc., even when heated, and to have excellent heat resistance.

It was found that, among these organic substances, the substrates on which n-octadecylphosphonic acid used in Example 24 or 2-(perfluorohexyl)ethylphosphonic acid used in Example 25 was deposited had particularly excellent heat resistance, and the organic substances deposited on the substrates had particularly high heat resistance because they did not disappear due to degradation but remained on the substrates, even when heated to 250°C or higher.

Moreover, a comparison between Examples 22 and 23 shows that while carboxylic acids of the same number of carbons were used, Example 23 using 2-(perfluorohexyl)propanoic acid in which hydrogen atoms have been replaced with fluorine atoms exhibited higher heat resistance. Similarly, comparisons between Examples 24 and 25 and between Examples 26 and 27 show that the heat resistance was also increased by replacing hydrogen atoms with fluorine atoms in a phosphonic acid or thiol.

### [Example 28]

### (Preparation of solution)

Ethanol (EtOH) as a solvent and n-octadecylphosphonic acid as an organic substance were mixed and dissolved so that the organic substance was at a concentration of 1 mass%, whereby a solution A was prepared. Moreover, ethanol (EtOH) as a solvent and n-octadecanethiol as an organic substance were mixed and dissolved so that the organic substance was at a concentration of 1 mass%, whereby a solution B was prepared.

### (Surface treatment with solution containing organic substance)

A CoOₓ-containing substrate, a Co-containing substrate, and a SiOₓ-containing substrate each prepared as described above in "Preparation of substrate" were each immersed in the solution A at 22°C for 0.5 hours and subsequently immersed in IPA for 60 seconds twice.
Further, each substrate was immersed in the solution B at 22°C for 0.5 hours for surface treatment of the substrate to deposit the organic substance on the surface of the substrate. Subsequently, each substrate was immersed in IPA for 60 seconds twice, and nitrogen gas was sprayed for 60 seconds to dry the substrate.

### [Examples 29 to 31]

The procedure was repeated as in Example 28, except that the type of the organic substance, the types of the solutions A and B, and the immersion times of the solutions A and B were changed as shown in Table 5, followed by evaluation.

### (Measurement of contact angle with water)

Pure water (about 1 ul) was placed on the surface of each of the substrates according to Examples 28 to 31, and the angle (contact angle) between a water droplet and the wafer surface was measured by a contact angle meter (DM-301 available from Kyowa Interface Science Co., Ltd.). Table 5 shows the results together with the results of Example 3.

**[Table 5]**

| | Solution A | | | | Solvent B | | | | Immersion time (hr) | | Contact angle (°) | | |
|---|---|---|---|---|---|---|---|---|---|---|---|---|---|
| | Organic substance | Number of carbons of organic substance | Organic substance concentration (mass%) | Solvent | Organic substance | Number of carbons of organic substance | Organic substance concentration (mass%) | Solvent | Solution A | Solution B | CoOx | Co | SiOx |
| Example 3 | n-Octadecylphosphonic acid | 18 | 1 | IPA | - | - | - | - | 24 | - | 112 | 109 | 38 |
| Example 28 | n-Octadecylphosphonic acid | 18 | 1 | EtOH | n-Octadecanethiol | 18 | 1 | EtOH | 0.5 | 0.5 | 109 | 109 | 34 |
| Example 29 | n-Octadecylphosphonic acid | 18 | 1 | EtOH | n-Octadecanethiol | 18 | 1 | EtOH | 0.8 | 0.2 | 108 | 108 | 30 |
| Example 30 | n-Octadecanethiol | 18 | 1 | EtOH | n-Octadecylphosphonic acid | 18 | 1 | EtOH | 0.5 | 0.5 | 108 | 108 | 31 |
| Example 31 | n-Octadecylphosphonic acid | 18 | 1 | EtOH | n-Dodecanethiol | 12 | 1 | EtOH | 0.5 | 0.5 | 106 | 106 | 30 |

As is clear from the results in Table 5, in each of Examples 28 to 31, the Co-containing substrate and the CoOₓ-containing substrate each had a higher contact angle than the SiOₓ-containing substrate, demonstrating that the use of two solutions each containing an organic substance of formula (1) as organic substances allows films of the organic substances to be deposited selectively on a metal or metal oxide surface.

Moreover, comparisons between Example 3 and Examples 28 to 31 show that when treated with the two solutions each containing an organic substance for a short time of one hour, the Co-containing substrates and CoOₓ-containing substrates each had a contact angle substantially as high as that in Example 3. Moreover, a comparison between Example 28 and Example 31 shows that the contact angle increased when the number of carbons of the organic substance in the solution B was higher compared to the number of carbons of the organic substance in the solution A.

### [Example 32]

### (Preparation of solution)

Ethanol (EtOH) as a solvent and (10-phenyldecyl)phosphonic acid as an organic substance were mixed and dissolved so that the organic substance was at a concentration of 1 mass%, whereby a solution was prepared.

### (Surface treatment with solution containing organic substance)

A CoOₓ-containing substrate, a Co-containing substrate, and a SiOₓ-containing substrate each prepared as described above in "Preparation of substrate" were each immersed in the solution at 22°C for one hour for surface treatment of the substrate to deposit the organic substance on the surface of the substrate. Subsequently, each substrate was immersed in IPA for 60 seconds twice, and nitrogen gas was sprayed for 60 seconds to dry the substrate.

### (Measurement of contact angle with water)

Pure water (about 1 ul) was placed on the surface of each of the substrates according to Example 32, and the angle (contact angle) between a water droplet and the wafer surface was measured by a contact angle meter (DM-301 available from Kyowa Interface Science Co., Ltd.). Table 6 shows the results together with the results of Example 3.

### [Examples 33 and 34]

The procedure was repeated as in Example 32, except that polyethylene glycol methyl ether phosphonic acid-15 represented by the following formula (12) or polyethylene glycol methyl ether phosphonic acid-11 represented by the following formula (13) was used as the organic substance, followed by evaluation. Table 6 shows the results.

CH₃-O-(CH₂CH₂O)₁₁-CH₂CH₂-PO₃H₂ (12)

CH₃-O-(CH₂CH₂O)₁₅-CH₂CH₂-PO₃H₂ (13)

**[Table 6]**

| | Organic substance | Organic substance concentration (mass%) | Solvent | Immersion time (hr) | Contact angle (°) | | |
|---|---|---|---|---|---|---|---|
| | | | | | CoOx | Co | SiOx |
| Example 3 | n-Octadecylphosphonic acid | 1 | IPA | 24 | 112 | 109 | 38 |
| Example 32 | (10-Phenyldecyl)phosphonic acid | 1 | EtOH | 1 | 90 | 91 | 40 |
| Example 33 | Polyethylene glycol methyl ether phosphonic acid -15 | 1 | EtOH | 1 | 41 | 40 | 18 |
| Example 34 | Polyethylene glycol methyl ether phosphonic acid -11 | 1 | EtOH | 1 | 45 | 43 | 20 |

As is clear from the results in Table 6, in each of Examples 32 to 34, the Co-containing substrate and the CoOₓ-containing substrate each had a higher contact angle than the SiOₓ-containing substrate, demonstrating that the use of an organic substance of formula (10) or (11) as an organic substance allows a film of the organic substance to be deposited selectively on a metal or metal oxide surface.

The present application claims priority under the Paris Convention and the law of the designated state to Japanese Patent Application No. 2021-014552 filed on February 1, 2021, the entire contents of which are hereby incorporated by reference.

## Claims

1. A selective film deposition method, comprising:
exposing a substrate having a structure on which a first surface region containing a metal element and a second surface region containing a nonmetal inorganic material are both exposed, to a solution containing an organic substance represented by formula (1) shown below and a solvent to deposit a film of the organic substance on the first surface region selectively over the second surface region:
R¹(X)ₘ (1)
wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

2. The selective film deposition method according to claim 1,
wherein the organic substance of formula (1) comprises at least one organic substance represented by at least one selected from the group consisting of the following formulas (2) to (5):
R³(PO₃(R⁴)₂)ₙ (2)
wherein R³ is a C4-C100 hydrocarbon group optionally containing a heteroatom or a halogen atom, and n hydrogen atoms of the hydrocarbon group are replaced with (PO₃(R⁴)₂); n is 1 or 2; R⁴ is a hydrogen atom or a C1-C6 alkyl group; and each R⁴ may be the same or different;
R⁵(O-PO₃(R⁶)₂)ₙ (3)
wherein R⁵ is a C4-C100 hydrocarbon group optionally containing a heteroatom or a halogen atom, and n hydrogen atoms of the hydrocarbon group are replaced with (O-PO₃(R⁶)₂); n is 1 or 2; R⁶ is a hydrogen atom or a C1-C6 alkyl group; and each R⁶ may be the same or different;
R⁷(CO₂R⁸)ₙ (4)
wherein R⁷ is a C4-C100 hydrocarbon group optionally containing a heteroatom or a halogen atom, and n hydrogen atoms of the hydrocarbon group are replaced with (CO₂R⁸); n is 1 or 2; R⁸ is a hydrogen atom or a C1-C6 alkyl group; and each R⁸ may be the same or different; and
R⁹(SR¹⁰)ₙ (5)
wherein R⁹ is a C4-C100 hydrocarbon group optionally containing a heteroatom or a halogen atom, and n hydrogen atoms of the hydrocarbon group are replaced with (SR¹⁰); n is 1 or 2; R¹⁰ is a hydrogen atom, a C1-C6 alkyl group, or -S-R⁹; and each R¹⁰ may be the same or different.

3. The selective film deposition method according to claim 1 or 2,
wherein the substrate is exposed to the solution to obtain a substrate in which a contact angle with water is higher in the first surface region than in the second surface region.

4. The selective film deposition method according to claim 3,
wherein a substrate is obtained in which a contact angle with water is higher by at least 10° in the first surface region than in the second surface region.

5. The selective film deposition method according to claim 2,
wherein R⁴, R⁶, R⁸, and R¹⁰ in formulas (2) to (5) are hydrogen atoms.

6. The selective film deposition method according to any one of claims 1 to 5,
wherein the metal element is contained in the form of a metal or a metal oxide, and
the metal is at least one selected from the group consisting of Cu, Co, Ru, Ni, Pt, Al, Ta, Ti, and Hf, and the metal oxide is at least one oxide of at least one metal selected from the group consisting of Cu, Co, Ru, Ni, Pt, Al, Ta, Ti, and Hf.

7. The selective film deposition method according to any one of claims 1 to 6,
wherein the nonmetal inorganic material is at least one selected from the group consisting of silicon, silicon oxide, silicon nitride, and silicon oxynitride.

8. The selective film deposition method according to any one of claims 1 to 7,
wherein a concentration of the organic substance of formula (1) in the solution is at least 0.01 mass% but not more than 20 mass% based on 100 mass% of a total amount of the solution.

9. The selective film deposition method according to any one of claims 1 to 8,
wherein the solvent is an organic solvent.

10. The selective film deposition method according to claim 9,
wherein the organic solvent comprises at least one selected from the group consisting of esters, ethers, ketones, alcohol-based solvents, and polyhydric alcohol derivatives.

11. The selective film deposition method according to claim 10,
wherein the organic solvent comprises ethanol or isopropyl alcohol.

12. The selective film deposition method according to any one of claims 1 to 11,
wherein the organic substance of formula (1) comprises at least one organic substance represented by at least one selected from the group consisting of the following formulas (6) to (9):
R¹¹-PO₃H₂ (6)
wherein R¹¹ is a C6-C100 monovalent hydrocarbon group optionally containing a heteroatom or a halogen atom;
R¹²-O-PO₃H₂ (7)
wherein R¹² is a C6-C100 monovalent hydrocarbon group optionally containing a heteroatom or a halogen atom;
R¹³-CO₂H (8)
wherein R¹³ is a C6-C100 monovalent hydrocarbon group optionally containing a heteroatom or a halogen atom; and
R¹⁴-SH (9)
wherein R¹⁴ is a C6-C100 monovalent hydrocarbon group optionally containing a heteroatom or a halogen atom.

13. The selective film deposition method according to claim 12,
wherein the organic substance of formula (1) comprises at least one organic substance represented by at least one selected from the group consisting of formula (6) and formula (7).

14. The selective film deposition method according to claim 12,
wherein the organic substance of formula (1) comprises an organic substance of formula (8).

15. The selective film deposition method according to claim 12,
wherein the organic substance of formula (1) comprises an organic substance of formula (9).

16. The selective film deposition method according to any one of claims 12 to 15,
wherein R¹¹, R¹², R¹³, and R¹⁴ are each a hydrocarbon group whose hydrogen atoms are partially or fully replaced with fluorine atoms.

17. The selective film deposition method according to any one of claims 12 to 15,
wherein R¹¹, R¹², R¹³, and R¹⁴ are each a monovalent organic group represented by the following formula (10):
R¹⁵-(CH₂)ₙ- (10)
wherein R¹⁵ is a hydrogen atom or a monovalent hydrocarbon group optionally containing a heteroatom or a halogen atom; and n is an integer of 2 to 20, and the total number of carbons in formula (10) is 6 to 100.

18. The selective film deposition method according to any one of claims 12 to 15,
wherein R¹¹, R¹², R¹³, and R¹⁴ are each a monovalent organic group represented by the following formula (11):
R¹⁶-O-Y-((CH₂)ₚO)_{q}-Z-(CH₂)ᵣ- (11)
wherein R¹⁶ is a hydrogen atom, a methyl group, or a phenyl group; Y and Z are each any divalent group or a direct bond; p is an integer of 1 to 4, and q and r are positive integers; the total number of carbons in formula (11) is 6 to 100; and the repeating units (CH₂)ₚO and CH₂ may be present in any order in the formula.

19. The selective film deposition method according to any one of claims 1 to 18,
wherein the substrate is washed with a solvent after the film of the organic substance of formula (1) is selectively deposited on the substrate.

20. The selective film deposition method according to any one of claims 1 to 19,
wherein two or more solutions are provided as the solution, and the substrate is sequentially exposed to the solutions.

21. The selective film deposition method according to claim 20,
wherein the number of carbons of R¹ for the organic substance in the second or subsequent solution to which the substrate is exposed is greater than or equal to the number of carbons of R¹ for the organic substance in the first solution to which the substrate is exposed.

22. A solution for use in the selective film deposition method according to any one of claims 1 to 21, comprising:
an organic substance represented by the following formula (1); and a solvent:
R¹(X)ₘ (1)
wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

23. The solution according to claim 22,
wherein the solvent comprises ethanol or isopropyl alcohol, and a concentration of the organic substance of formula (1) is at least 0.01 mass% but not more than 20 mass% based on 100 mass% of a total amount of the solution.

24. A substrate, comprising:
a first surface region containing a metal element; and a second surface region containing a nonmetal inorganic material,
wherein the first surface region comprises a film of an organic substance represented by formula (1) shown below, and the second surface region comprises no film of the organic substance or a film of the organic substance on the second surface region has a thickness t₂ smaller than a thickness t₁ of the film of the organic substance on the first surface region:
R¹(X)ₘ (1)
wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

25. The substrate according to claim 24,
wherein a contact angle with water is higher in the first surface region than in the second surface region.

26. The substrate according to claim 25,
wherein the contact angle with water is higher by at least 10° in the first surface region than in the second surface region.

27. An organic substance deposited film, formed by the selective film deposition method according to any one of claims 1 to 21,
wherein the deposited film comprises an organic substance represented by the following formula (1) deposited on a substrate:
R¹(X)ₘ (1)
wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.

28. An organic substance, represented by the following formula (1) for use in the selective film deposition method according to any one of claims 1 to 21:
R¹(X)ₘ (1)
wherein R¹ is a C4-C100 hydrocarbon group optionally containing a heteroatom or a halogen atom, and m hydrogen atoms of the hydrocarbon group are replaced with X; X is - PO₃(R²)₂, -O-PO₃(R²)₂, -CO₂R², -SR², or -SSR¹; each R² is a hydrogen atom or a C1-C6 alkyl group; and m is a positive integer, and m/r is 0.01 to 0.25 where r is the number of carbons of the hydrocarbon group.
